# EUROPEAN PATENT APPLICATION

(11) **EP 4 579 766 A1**
(43) Date of publication of application: **02.07.2025**
(21) Application number: 23882336.3
(22) Date of filing: 28.09.2023
(51) Int. Cl.: H01L 31/055, B64U 50/31

(54) **PHOTOELECTRIC CONVERSION DEVICE AND FLYING OBJECT**

(30) Priority: 28.10.2022 JP 2022173293
(71) Applicant: Softbank Corp., Tokyo 105-7529 (JP)
(72) Inventor: UEDA Marika, Tokyo 105-7529 (JP); KIYAMA Seiichi, Tokyo 105-7529 (JP)
(74) Representative: Michalski Hüttermann & Partner Patentanwälte mbB
(86) International application number: PCT/JP2023/035377
(87) International publication number: WO 2024/090127

(57) **Abstract**

A photoelectric conversion apparatus includes: a photoelectric conversion element which converts light energy of incident light into electric energy; a first wavelength conversion layer which is disposed in contact with a light receiving surface of the photoelectric conversion element; and a second wavelength conversion layer which is disposed on a side of a surface of the first wavelength conversion layer opposite to a surface in contact with the photoelectric conversion element. The first wavelength conversion layer contains a first wavelength conversion material which converts a wavelength of light in a first wavelength region. The second wavelength conversion layer contains a second wavelength conversion material which converts a wavelength of light in a second wavelength region. An upper limit value of the first wavelength region is different from an upper limit value of the second wavelength region, and/or a lower limit value of the first wavelength region is different from a lower limit value of the second wavelength region.

## Description

### BACKGROUND

### 1. TECHNICAL FIELD

The present invention relates to a photoelectric conversion apparatus and a flight vehicle.

### 2. RELATED ART

Patent Documents 1 to 8 disclose a solar cell including a wavelength conversion layer containing one or more wavelength conversion substances.

### Prior Art Documents

### Patent Documents

Patent Document 1: Japanese Patent Application Publication No. H07-142752
Patent Document 2: Japanese Patent Application Publication No. 2016-145295
Patent Document 3: Japanese Patent Application Publication No. 2019-215451
Patent Document 4: Japanese Patent Application Publication No. 2019-050381
Patent Document 5: Japanese Patent Application Publication No. 2022-056319
Patent Document 6: Japanese Patent Application Publication No. 2013-069728
Patent Document 7: Japanese Patent Application Publication No. 2013-123037
Patent Document 8: Japanese Patent Application Publication No. 2012-142346

### Technical Problem

In a case where a solar cell is installed in an environment with an air mass (may be abbreviated as AM) 0, such as the stratosphere or outer atmosphere, the amount of light in an ultraviolet light region incident on the solar cell increases compared to a case where the solar cell is installed on the ground (for example, in an environment with AM1 or AM1.5). In a case where a solar cell is used in an environment of AM0, it is desirable to effectively use light in the ultraviolet light region. In particular, in a case where a solar cell is mounted on a flight vehicle flying in the stratosphere, it is desirable to develop a solar cell that is lightweight and excellent in power generation efficiency.

### SUMMARY

In a first aspect of the present invention, a photoelectric conversion apparatus is provided. The photoelectric conversion apparatus includes, for example, a photoelectric conversion element which converts light energy of incident light into electric energy. The photoelectric conversion apparatus includes, for example, a first wavelength conversion layer which is disposed in contact with a light receiving surface of the photoelectric conversion element. The photoelectric conversion apparatus includes, for example, a second wavelength conversion layer which is disposed on a side of a surface of the first wavelength conversion layer opposite to a surface in contact with the photoelectric conversion element. In the photoelectric conversion apparatus, the first wavelength conversion layer contains, for example, a first wavelength conversion material which converts a wavelength of light in a first wavelength region. In the photoelectric conversion apparatus, the second wavelength conversion layer contains, for example, a second wavelength conversion material which converts a wavelength of light in a second wavelength region. In the photoelectric conversion apparatus, for example, an upper limit value of the first wavelength region is different from an upper limit value of the second wavelength region, and/or a lower limit value of the first wavelength region is different from a lower limit value of the second wavelength region.

In any one of the photoelectric conversion apparatuses described above, the first wavelength region may include a third wavelength region included in a range of 100 nm or more and 400 nm or less. In any one of the photoelectric conversion apparatuses described above, the second wavelength region includes a fourth wavelength region included in a range of 100 nm or more and 400 nm or less, and in any one of the photoelectric conversion apparatuses described above, for example, an upper limit value of the third wavelength region is different from an upper limit value of the fourth wavelength region, and/or a lower limit value of the third wavelength region is different from a lower limit value of the fourth wavelength region.

In any one of the photoelectric conversion apparatuses described above, the first wavelength conversion layer may contain a first resin and the first wavelength conversion material. In any one of the photoelectric conversion apparatuses described above, the second wavelength conversion layer may contain a second resin and the second wavelength conversion material. In any one of the photoelectric conversion apparatuses described above, the first resin and the second resin may be different in type and/or composition. In any one of the photoelectric conversion apparatuses described above, the first wavelength conversion layer may have a refractive index larger than that of the second wavelength conversion layer.

In any one of the photoelectric conversion apparatuses described above, the first resin may be at least one type selected from an ethylene-vinyl acetate copolymer resin (EVA), a polyolefin elastomer (POE), a silicone resin (SI), or an ionomer resin. In any one of the photoelectric conversion apparatuses described above, the second resin may be at least one type selected from a group consisting of polyethylene (PE), ultra-high molecular weight polyethylene (U-PE), polymethyl methacrylate (PMMA), polyethylene terephthalate (PET), polycarbonate (PC), a fluorine-based resin, polyimide (PI), unsaturated polyester (UP), an epoxy resin (EP), and a silicone resin (SI).

In any one of the photoelectric conversion apparatuses described above, the first wavelength conversion layer may be disposed so as to cover the light receiving surface of the photoelectric conversion element and at least a part of a side surface of the photoelectric conversion element. In any one of the photoelectric conversion apparatuses described above, the first wavelength conversion layer may have a thickness of 20 µm or more and 100 µm or less.

In any one of the photoelectric conversion apparatuses described above, the first wavelength conversion layer may have a thickness of less than 10 µm. In any one of the photoelectric conversion apparatuses described above, the second wavelength conversion layer may be disposed so as to cover the first wavelength conversion layer disposed on the light receiving surface of the photoelectric conversion element and at least a part of a side surface of the photoelectric conversion element. In any one of the photoelectric conversion apparatuses described above, the photoelectric conversion apparatus may include an intermediate layer which is disposed between the first wavelength conversion layer and the second wavelength conversion layer. The intermediate layer may be disposed so as to cover the first wavelength conversion layer disposed on the light receiving surface of the photoelectric conversion element and at least a part of a side surface of the photoelectric conversion element.

In any one of the photoelectric conversion apparatuses described above, the second wavelength conversion layer may have a thickness of 20 µm or more and 50 µm or less. In any one of the photoelectric conversion apparatuses described above, the first wavelength conversion layer may have a transmittance of 80% or more for light of 200 nm to 450 nm. In any one of the photoelectric conversion apparatuses described above, the second wavelength conversion layer may have a transmittance of 90% or more for light of 200 nm to 450 nm.

In any one of the photoelectric conversion apparatuses described above, the first wavelength conversion material may contain an organic phosphor. In any one of the photoelectric conversion apparatuses described above, the second wavelength conversion material may contain an inorganic phosphor.

In any one of the photoelectric conversion apparatuses described above, the first wavelength conversion layer may have an absorption layer which is disposed in contact with a light receiving surface of the photoelectric conversion element and contains a UV absorbing material. The first wavelength conversion layer may have a conversion layer which is disposed on a side of a surface of the UV absorption layer opposite to a surface in contact with the photoelectric conversion element and contains the first wavelength conversion material.

In a second aspect of the present invention, a flight vehicle is provided. The flight vehicle includes, for example, any of the photoelectric conversion apparatuses according to the first aspect. The flight vehicle includes, for example, a propulsion force generation apparatus which generates a propulsion force by using electric energy generated by the photoelectric conversion apparatus.

The summary clause does not necessarily describe all necessary features of the embodiments of the present invention. The present invention may also be a sub-combination of the features described above.

### BRIEF DESCRIPTION OF THE DRAWINGS

Fig. 1 schematically illustrates an example of a system configuration of a flight vehicle 100.
Fig. 2 schematically illustrates an example of an internal configuration of a photovoltaic module 112.
Fig. 3 schematically illustrates an example of an internal configuration of a photovoltaic module 312.
Fig. 4 schematically illustrates another example of the internal configuration of the photovoltaic module 312.
Fig. 5 schematically illustrates an example of an internal configuration of a photovoltaic module 512.
Fig. 6 schematically illustrates another example of the internal configuration of the photovoltaic module 512.
Fig. 7 schematically illustrates an example of an internal configuration of a photovoltaic module 712.
Fig. 8 schematically illustrates an example of an internal configuration of a photovoltaic module 812.
Fig. 9 schematically illustrates an example of an internal configuration of a photovoltaic module 912.
Fig. 10 schematically illustrates an example of an internal configuration of a photovoltaic module 1012.

### DESCRIPTION OF EXEMPLARY EMBODIMENTS

According to an exemplary embodiment disclosed in the present specification, a photoelectric conversion apparatus includes a photoelectric conversion element which converts light energy of incident light into electric energy, a first wavelength conversion layer which is disposed in contact with a light receiving surface of the photoelectric conversion element, and a second wavelength conversion layer which is disposed on a side of a surface of the first wavelength conversion layer opposite to a surface in contact with the photoelectric conversion element. The first wavelength conversion layer contains a first wavelength conversion material which converts a wavelength of light in a first wavelength region. The second wavelength conversion layer contains a second wavelength conversion material that converts a wavelength of light in a second wavelength region.

In the present embodiment, a numerical range of the first wavelength region and a numerical range of the second wavelength region are different from each other. (I) The numerical range of the first wavelength region and the numerical range of the second wavelength region may be completely separated, (ii) a part of the numerical range of the first wavelength region and a part of the numerical range of the second wavelength region may overlap, (iii) the numerical range of the first wavelength region may be included inside the numerical range of the second wavelength region, or (iv) the numerical range of the second wavelength region may be included inside the numerical range of the first wavelength region.

In one embodiment, an upper limit value of the first wavelength region is different from an upper limit value of the second wavelength region. The upper limit value of the first wavelength region may be larger than the upper limit value of the second wavelength region. The upper limit value of the first wavelength region may be smaller than the upper limit value of the second wavelength region. In another embodiment, a lower limit value of the first wavelength region is different from a lower limit value of the second wavelength region. The lower limit value of the first wavelength region may be larger than the lower limit value of the second wavelength region. The lower limit value of the first wavelength region may be smaller than the lower limit value of the second wavelength region.

The first wavelength conversion material and the second wavelength conversion material can convert the wavelength of light by using, for example, a non-linear optical effect, an up-conversion phenomenon, a down-conversion phenomenon, or the like. A substance that converts the wavelength of light by using the up-conversion phenomenon (may be referred to as an up-conversion substance) is excited by, for example, light having a specific wavelength or an electromagnetic wave, and emits light having a wavelength shorter than a wavelength of the light or the electromagnetic wave (may be referred to as emitting light, radiating light, or the like). A substance that converts the wavelength of light using the down-conversion phenomenon (may be referred to as a down-conversion substance) is excited by, for example, light having a specific wavelength or an electromagnetic wave, and emits light having a wavelength longer than a wavelength of the light or the electromagnetic wave (may be referred to as converting to a longer wavelength side).

The first wavelength conversion material, for example, is excited by light in the first wavelength region or absorbs the light in the first wavelength region to emit fluorescence. The second wavelength conversion material, for example, is excited by light in the second wavelength region or absorbs the light in the second wavelength region to emit fluorescence.

The photoelectric conversion element converts light energy of light incident on the photoelectric conversion element (may be referred to as input light) into electric energy by using, for example, a photovoltaic effect. A conversion efficiency of the photoelectric conversion element depends on a wavelength of the input light. For example, in the case of a silicon-based photoelectric conversion element, light in a wavelength region of visible light to near-infrared light can be converted relatively efficiently, but light in a wavelength region corresponding to ultraviolet light cannot be converted efficiently.

According to the present embodiment, light incident on the photoelectric conversion apparatus (may be referred to as incident light) is first incident on the second wavelength conversion layer. At least a part of a wavelength of the light incident on the second wavelength conversion layer is converted by the action of the second wavelength conversion material contained in the second wavelength conversion layer.

The second wavelength conversion material converts, for example, a wavelength of light having a wavelength of 100 nm or more and 400 nm or less. The second wavelength conversion material is, for example, excited by the light having a wavelength of 100 nm or more and 400 nm or less (may be referred to as excitation light) to emit fluorescence having a wavelength longer than that of the excitation light. Accordingly, for example, ultraviolet light included in the incident light is converted into light having a wavelength from the ultraviolet light. As a result, a progress of deterioration of at least one of the photoelectric conversion element, the first wavelength conversion layer, or the first wavelength conversion material is suppressed. In addition, the conversion efficiency of the photoelectric conversion element can be improved.

The second wavelength conversion material may convert a wavelength of light having a wavelength longer than that of the light of which the wavelength is converted by the first wavelength conversion material. In this case, the first wavelength region and the second wavelength region may include at least a part of the wavelength region corresponding to ultraviolet light (may be referred to as an ultraviolet light region). Examples of the ultraviolet light region include UV-A (315 to 400 nm), UV-B (280 to 315 nm), UV-C (100 to 280 nm), and the like. The first wavelength conversion material and the second wavelength conversion material may be down-conversion substances. Accordingly, the deterioration of the photoelectric conversion element due to the ultraviolet light included in the incident light is suppressed.

In the environment of AM0, the amount of light of UV-C is larger than that in the environment on the ground. In this regard, at least one of the first wavelength region or the second wavelength region may include at least a part of the wavelength region corresponding to UV-C. Accordingly, the photoelectric conversion apparatus particularly suitable for use in installation in a flight vehicle flying in the environment of AM0 is provided.

The second wavelength conversion material may convert a wavelength of light having a wavelength shorter than that of the light of which the wavelength is converted by the first wavelength conversion material. In one embodiment, the second wavelength region may include at least a part of the ultraviolet light region. In another embodiment, the first wavelength region and the second wavelength region may include at least a part of the ultraviolet light region. In these embodiments, the second wavelength region may include at least a part of the wavelength region corresponding to UV-C. Accordingly, the photoelectric conversion apparatus particularly suitable for use in installation in a flight vehicle flying in the environment of AM0 is provided.

The second wavelength conversion material may be a down-conversion substance. The first wavelength conversion material and the second wavelength conversion material may also be down-conversion substances. As described above, according to the present embodiment, the light incident on the photoelectric conversion apparatus is incident on the second wavelength conversion layer, the first wavelength conversion layer, and the photoelectric conversion element in this order. When the second wavelength conversion material contained in the second wavelength conversion layer converts the wavelength of light in the second wavelength region to a longer wavelength side, not only deterioration of the photoelectric conversion element due to ultraviolet light but also deterioration of the first wavelength conversion material due to ultraviolet light can be suppressed.

In one embodiment, the second wavelength conversion material emits light having a wavelength at which the conversion efficiency by the photoelectric conversion element is relatively excellent. For example, the second wavelength conversion material emits light having a wavelength of 400 nm or more. Accordingly, the conversion efficiency of the photoelectric conversion apparatus is improved. In another embodiment, the second wavelength conversion material emits light in the first wavelength region. In this case, the photoelectric conversion apparatus may be configured such that the light emitted from the second wavelength conversion material is incident on the photoelectric conversion element after the wavelength thereof is converted by the first wavelength conversion material. Note that even in this case, the light in the first wavelength region may include light having a wavelength of 400 nm or more. Accordingly, the conversion efficiency of the photoelectric conversion apparatus is improved.

Next, the light transmitted through the second wavelength conversion layer is transmitted through the first wavelength conversion layer and is incident on the photoelectric conversion element. At this time, at least a part of a wavelength of the light incident on the first wavelength conversion layer is converted by the action of the first wavelength conversion material contained in the first wavelength conversion layer.

The light incident on the first wavelength conversion layer includes (i) incident light transmitted through the second wavelength conversion layer without being converted in wavelength by the second wavelength conversion material, and (ii) light emitted by the second wavelength conversion material. The first wavelength conversion material may convert the wavelength of the incident light, may convert the wavelength of the light emitted by the second wavelength conversion material, or may convert both wavelengths.

The first wavelength conversion material converts, for example, a wavelength of light having a wavelength of 100 nm or more and 400 nm or less. The first wavelength conversion material is, for example, excited by the light having a wavelength of 100 nm or more and 400 nm or less (may be referred to as excitation light) to emit fluorescence having a wavelength longer than that of the excitation light. Accordingly, the ultraviolet light included in the light incident on the first wavelength conversion layer is converted into light having a wavelength from the ultraviolet light. Accordingly, a progress of deterioration of at least one of the photoelectric conversion element, the first wavelength conversion layer, or the first wavelength conversion material is suppressed.

The first wavelength conversion material emits light having a wavelength at which the conversion efficiency by the photoelectric conversion element is relatively excellent, for example. Accordingly, the conversion efficiency of the photoelectric conversion element can be improved.

According to the present embodiment, for example, the first wavelength conversion layer and the second wavelength conversion layer convert light in a wavelength region where the conversion efficiency by the photoelectric conversion element is relatively low into light in a wavelength region where the conversion efficiency by the photoelectric conversion element is relatively high. Accordingly, the photoelectric conversion apparatus according to the present embodiment can efficiently convert light energy of light incident on the photoelectric conversion apparatus into electric energy. As a result, the power generation amount per unit mass of the photoelectric conversion apparatus is improved. In particular, in the stratospheric environment, the amount of ultraviolet light is larger than that on the ground. Therefore, when the photoelectric conversion apparatus according to the present embodiment is mounted on a flight vehicle that flies in the stratosphere, a flyable distance, a flyable time, and/or a flyable latitude range of the flight vehicle are improved.

In a case where all the wavelength conversion materials included in the photoelectric conversion apparatus are added to a single layer, there is a possibility that the light transmittance of the single layer is reduced. As a result, the effect of wavelength conversion of light by the wavelength conversion material can also be reduced. On the other hand, according to the present embodiment, two or more types of wavelength conversion materials having different conversion characteristics and/or compositions are disposed in a plurality of physically different layers. Accordingly, the effect of the wavelength conversion material converting the wavelength of light can be sufficiently exhibited.

In addition, by using two or more types of wavelength conversion materials, a wide range of wavelengths of light can be converted as compared with a case where a single type of wavelength conversion material is used. For example, a proportion of light, which is converted into light in the visible light region, to light in the ultraviolet region included in the incident light increases. As a result, the power generation efficiency of the photoelectric conversion apparatus is improved, and the power generation amount per unit mass is increased. Therefore, when the photoelectric conversion apparatus according to the present embodiment is mounted on a flight vehicle that flies in the stratosphere, a flyable distance, a flyable time, and a flyable range (for example, a range of latitude) of the flight vehicle are improved.

Conventionally, a solar panel arranged on the ground includes an encapsulation layer that protects the solar cell from oxygen and moisture, and a front surface protection layer that protects the encapsulation layer from an external environment. Generally, the encapsulation layer has a thickness of several hundred µm and the front surface protection layer has a thickness of several mm. On the other hand, according to the present embodiment, the second wavelength conversion layer has a thickness of, for example, 20 µm or more and 50 µm or less. In addition, the first wavelength conversion layer has a thickness of 20 µm or more and 100 µm or less, or a thickness of less than 0.1 µm, for example. Accordingly, for example, the photoelectric conversion apparatus of 500 g/m² or less can be provided. Therefore, when the photoelectric conversion apparatus according to the present embodiment is mounted on a flight vehicle flying in the stratosphere, a flyable distance and/or a flyable time of the flight vehicle are improved.

According to the photoelectric conversion apparatus according to the present embodiment, for example, a solar power generation apparatus having excellent power generation efficiency per unit mass can be realized. The solar power generation apparatus is known as a power generation method with a small emission amount of carbon dioxide. For example, the solar power generation apparatus is brought to a disaster site and used for supplying energy to disaster victims. Therefore, the photoelectric conversion apparatus according to the present embodiment can contribute to achievement of Goal 7 "Affordable and Clean Energy", Goal 13 "Specific Measures against Climate Change", or the like of Sustainable Development Goals (SDGs).

Hereinafter, the present invention will be described through embodiments of the invention, but the following embodiments do not limit the invention according to the claims. In addition, not all of the combinations of features described in the embodiments are essential to the solution of the invention.

In the present specification, when a numerical range is expressed as "from A to B", the expression means A or more and B or less. In addition, "substituted or unsubstituted" means "substituted with any substituent, or not substituted with a substituent". A type of substituent described above is not particularly limited unless otherwise stated in the specification. In addition, the number of substituents described above is not particularly limited unless otherwise stated in the specification.

### (Overview of flight vehicle 100)

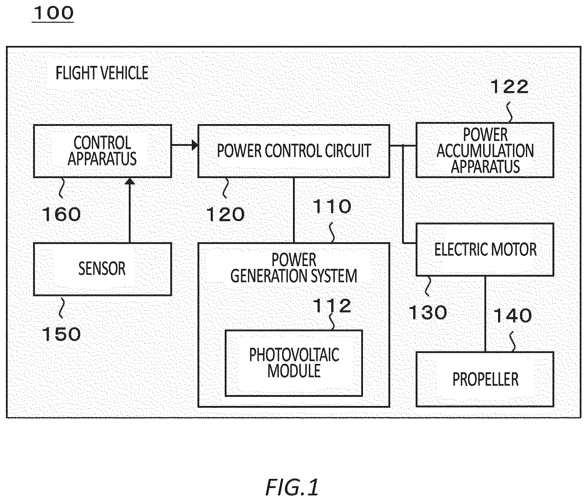

Fig. 1 schematically illustrates an example of a system configuration of a flight vehicle 100. In the present embodiment, the flight vehicle 100 includes a power generation system 110, a power control circuit 120, a power accumulation apparatus 122, one or more electric motors 130, one or more propellers 140, one or more sensors 150, and a control apparatus 160. In the present embodiment, the power generation system 110 includes one or more photovoltaic modules 112.

In the present embodiment, the flight vehicle 100 flies by using the electric energy generated by the power generation system 110. In the present embodiment, the electric energy generated by the power generation system 110 can be accumulated in the power accumulation apparatus 122. The flight vehicle 100 may fly by using the electric energy accumulated in the power accumulation apparatus 122. Examples of the flight vehicle 100 include an airplane, an air ship or a balloon, a hot-air balloon, a helicopter, a drone, and the like.

In the present embodiment, the power generation system 110 generates electric power. In the present embodiment, the power generation system 110 supplies the electric power to the power accumulation apparatus 122 and/or the electric motor 130 via the power control circuit 120.

In the present embodiment, the photovoltaic module 112 generates electric power by converting the light energy of light incident on the photovoltaic module 112 into electric energy. The photovoltaic module 112 will be described in detail later.

In the present embodiment, the power accumulation apparatus 122 accumulates electric energy (may be referred to as charging of the power accumulation apparatus 122). For example, the power accumulation apparatus 122 accumulates electric energy obtained by the power generation system 110 generating electric power. In addition, the power accumulation apparatus 122 discharges accumulated electric energy (may be referred to as discharging of the power accumulation apparatus 122). For example, the power accumulation apparatus 122 supplies electric power to the electric motor 130. The power accumulation apparatus 122 may include a secondary battery.

In the present embodiment, the power control circuit 120 controls output of the electric power generated by the power generation system 110. The power control circuit 120 may control input and output of the electric power of the power accumulation apparatus 122. In one embodiment, the power control circuit 120 supplies the electric power generated by the power generation system 110 to the power accumulation apparatus 122 and/or the electric motor 130. In another embodiment, the power control circuit 120 supplies the electric power accumulated in the power accumulation apparatus 122 to the electric motor 130. The power control circuit 120 may control the input and/or output of the electric power, based on a command from the control apparatus 160. The power control circuit 120 includes, for example, one or more switching elements that operate based on a control signal from the control apparatus 160. The power control circuit 120 may include one or more power conversion apparatuses that operate based on a control signal from the control apparatus 160.

In the present embodiment, the electric motor 130 receives electric energy from the power generation system 110 and/or the power accumulation apparatus 122 via the power control circuit 120. The electric motor 130 uses the electric energy received from the power generation system 110 and/or the power accumulation apparatus 122 to rotate the propeller 140. Accordingly, the electric motor 130 can generate a propulsion force of the flight vehicle 100 by using the electric energy generated by the power generation system 110.

In the present embodiment, the sensor 150 measures various physical quantities related to the position and posture of the flight vehicle 100. Examples of the sensor for measuring various physical quantities related to the position and posture of the flight vehicle 100 include a GPS signal receiver, an acceleration sensor, an angular acceleration sensor, a gyro sensor, and the like. The sensor 150 may measure various physical quantities related to the state of the power generation system 110 and/or the power accumulation apparatus 122. Examples of the sensor for measuring various physical quantities related to the state of the power generation system 110 and/or the power accumulation apparatus 122 include a temperature sensor, a current sensor, a voltage sensor, and the like.

In the present embodiment, the control apparatus 160 controls the flight vehicle 100. The control apparatus 160 may control the output of the electric power of the power generation system 110 by controlling the power control circuit 120. For example, the control apparatus 160 controls output power, output current, output voltage, and the like of the power generation system 110. The control apparatus 160 may control the input/output of the electric power of the power accumulation apparatus 122 by controlling the power control circuit 120. For example, the control apparatus 160 controls output power, output current, output voltage, input power, input current, input voltage, and the like of the power accumulation apparatus 122. Accordingly, the control apparatus 160 can control the position and posture of the flight vehicle 100. The control apparatus 160 may control the position and posture of the flight vehicle 100 by controlling the power control circuit 120 based on the output from the sensor 150.

The power generation system 110 may be an example of the photoelectric conversion apparatus. The photovoltaic module 112 may be an example of the photoelectric conversion apparatus. The electric motor 130 may be an example of the propulsion force generation apparatus.

### (Overview of photovoltaic module 112)

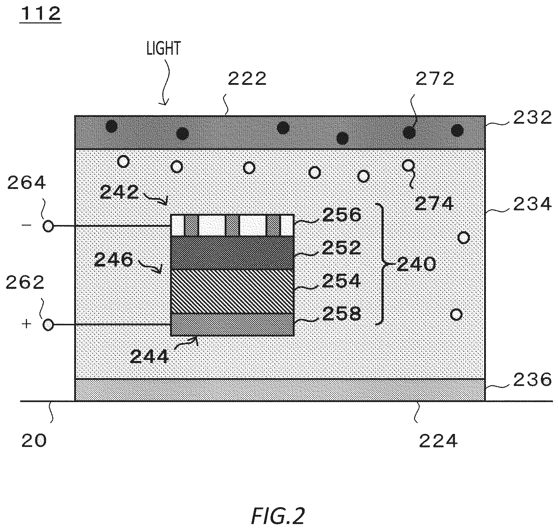

Fig. 2 schematically illustrates an example of an internal configuration of the photovoltaic module 112. In the present embodiment, the photovoltaic module 112 has, for example, a front surface 222 and a back surface 224. In the present embodiment, the photovoltaic module 112 includes, for example, a front surface protection layer 232, a sealing layer 234, a back surface protection layer 236, and a photoelectric conversion cell 240. In the present embodiment, the photoelectric conversion cell 240 has, for example, a front surface 242, a back surface 244, and a side surface 246 connecting the front surface 242 and the back surface 244. In the present embodiment, the photoelectric conversion cell 240 includes, for example, an n-type semiconductor layer 252, a p-type semiconductor layer 254, a light-receiving surface electrode 256, a back surface electrode 258, a positive electrode terminal 262, and a negative electrode terminal 264.

In the present embodiment, the front surface protection layer 232 contains a wavelength conversion material 272. The front surface protection layer 232 may also be a film or a coating made of the wavelength conversion material 272, or may also be a film or a coating containing the wavelength conversion material 272 and a resin material.

In the present embodiment, the sealing layer 234 contains a wavelength conversion material 274. The sealing layer 234 may also be a film or a coating made of the wavelength conversion material 274, or may also be a film or a coating containing the wavelength conversion material 272 and a resin material.

In the present embodiment, the front surface protection layer 232 protects the sealing layer 234 from the external environment. The front surface protection layer 232 protects the sealing layer 234 from oxygen, for example. The front surface protection layer 232 protects the sealing layer 234 from a temperature change or a low temperature, for example. The front surface protection layer 232 protects the sealing layer 234 from an impact caused by a change in atmospheric pressure, wind pressure, or the like, for example.

In the present embodiment, the front surface protection layer 232 is disposed on a side of a surface (an upper surface in the drawing) of the sealing layer 234 opposite to a surface (a lower surface in the drawing) in contact with the photoelectric conversion cell 240, among two surfaces of the sealing layer 234. The two surfaces of the sealing layer 234 may be surfaces substantially perpendicular to the thickness direction of the sealing layer 234.

More specifically, the front surface protection layer 232 is disposed on a side where light is incident, relative to the sealing layer 234. In one embodiment, the front surface protection layer 232 is disposed in contact with the surface of the sealing layer 234 on the side where light is incident. In another embodiment, another layer may be interposed between the front surface protection layer 232 and the sealing layer 234. Accordingly, according to the present embodiment, light is incident on the front surface protection layer 232 and the sealing layer 234 in this order.

The thickness of the front surface protection layer 232 may be 20 µm or more and 200 µm or less. The thickness of the front surface protection layer 232 is preferably 20 µm or more and 50 µm or less. Accordingly, the mass of the photovoltaic module 112 is reduced. The thickness of the front surface protection layer 232 may be determined such that the mass of the front surface protection layer 232 is 500 g/m² or less. The thickness of the front surface protection layer 232 may be determined such that the masses of the front surface protection layer 232 and the sealing layer 234 are 800 g/m² or less. The thickness of the front surface protection layer 232 may be determined such that the mass of the photovoltaic module 112 is 1200 g/m² or less. The thickness of the front surface protection layer 232 may be determined such that the mass of the photovoltaic module 112 is 500 g/m² or less. The mass of the photovoltaic module 112 may also be a mass per installation area of the photovoltaic module 112, or may also be a mass per area of a solar power generation panel.

### (Composition of front surface protection layer 232)

In the present embodiment, the front surface protection layer 232 contains a resin material (not illustrated) and the wavelength conversion material 272. The wavelength conversion material 272 will be described in detail later.

Examples of the resin material include at least one type selected from the group consisting of polyethylene (PE), ultra-high molecular weight polyethylene (U-PE), polymethyl methacrylate (PMMA), polyethylene terephthalate (PET), polycarbonate (PC), a fluorine-based resin, polyimide (PI), unsaturated polyester (UP), an epoxy resin (EP), and a silicone resin (SI). The molecular weight of the ultra-high molecular weight polyethylene (U-PE) may be on the order of 1 million to 7 million. Examples of the fluorine-based resin include polyvinylidene fluoride (PVDF), polytetrafluoroethylene (PTFE), fluorinated ethylene propylene copolymer (FEP), perfluoroalkoxy alkane (PFA), ethylene-tetrafluoroethylene copolymer (ETFE), polychlorotrifluoroethylene (PCTFE), ethylene-chlorotrifluoroethylene copolymer (ECTFE), polyvinyl fluoride (PVF), and the like.

Perfluoroalkoxy alkane (PFA) may be referred to as a tetrafluoroethylene-perfluoroalkoxyethylene copolymer resin. Fluorinated ethylene propylene copolymer (FEP) may be referred to as a tetrafluoroethylene-ethylene copolymer resin. Ethylene-chlorotrifluoroethylene copolymer (ECTFE) may be referred to as a trifluorochloroethylene-ethylene copolymer resin.

### (Optical characteristics of front surface protection layer 232)

The front surface protection layer 232 preferably has a refractive index similar to that of air or the atmosphere. The front surface protection layer 232 has, for example, a refractive index similar to that of air or the atmosphere in the stratospheric environment. Examples of the front surface protection layer 232 include glass having a refractive index of about 1.45 to 1.46, resin having a refractive index of about 1.42, and the like. Examples of the resin having a refractive index of about 1.42 include an ethylene-tetrafluoroethylene resin (ETFE resin).

The front surface protection layer 232 is preferably substantially transparent to ultraviolet light. The transmittance of light having a wavelength of 200 nm to 450 nm in the front surface protection layer 232 is preferably 90% or more, and more preferably 95% or more. The transmittance is measured by, for example, an ultraviolet-visible-near infrared spectrophotometer.

The front surface protection layer 232 is preferably substantially transparent to visible light and/or near-infrared light. The transmittance of light having a wavelength of 380 nm to 780 nm in the front surface protection layer 232 is preferably 90% or more, and more preferably 95% or more. The transmittance of light having a wavelength of 800 nm to 1600 nm in the front surface protection layer 232 is preferably 90% or more, and more preferably 95% or more. The transmittance is measured by, for example, an ultraviolet-visible-near infrared spectrophotometer.

### (Physical properties of front surface protection layer 232)

In the present embodiment, as the front surface protection layer 232, a material having durability of about half a year to 2 years in a stratospheric environment test is used. Examples of the temperature of the stratospheric environment include -88 degrees to 50 degrees. Examples of the atmospheric pressure of the stratospheric environment include 2 kPa to 101.3 kPa. Examples of the average atmospheric pressure of the stratospheric environment include 5 kPa or less. Examples of the humidity of the stratospheric environment include 0%RH to ground humidity. Examples of the ultraviolet light irradiated in the stratospheric environment include UV-A, UV-B, and UV-C. Examples of an ozone concentration in the stratospheric environment include 2ppm to 8ppm. Water may be present in the stratospheric environment.

The front surface protection layer 232 preferably has sufficient flexibility to be arranged along a wing surface shape of a flight vehicle flying in the stratospheric environment. The front surface protection layer 232 preferably has sufficient flexibility to cope with deflection and/or vibration generated when a flight vehicle flies in the stratospheric environment.

In the present embodiment, the sealing layer 234 seals the photoelectric conversion cell 240. The sealing layer 234 protects the photoelectric conversion cell 240 from oxygen and moisture, for example. The sealing layer 234 may seal a part of the photoelectric conversion cell 240 or may seal the entire photoelectric conversion cell 240. In one embodiment, the sealing layer 234 is disposed so as to cover at least a part of the front surface 242 of the photoelectric conversion cell 240. In another embodiment, the sealing layer 234 is disposed so as to cover at least a part of the side surface 246 of the photoelectric conversion cell 240.

In the embodiment illustrated in FIG 2, the sealing layer 234 seals the entire photoelectric conversion cell 240. In this case, a part of the sealing layer 234 is disposed between the front surface 242 of the photoelectric conversion cell 240 and the front surface protection layer 232. Similarly, a part of the sealing layer 234 is disposed between the back surface 244 of the photoelectric conversion cell 240 and the back surface protection layer 236.

The thickness of the sealing layer 234 may be 20 µm or more and 400 µm or less. The thickness of the sealing layer 234 is preferably 20 µm or more and 100 µm or less. Accordingly, the mass of the photovoltaic module 112 is reduced. The thickness of the sealing layer 234 may be determined such that the mass of the sealing layer 234 is 800 g/m² or less. The thickness of the sealing layer 234 may be determined such that the masses of the front surface protection layer 232 and the sealing layer 234 are 1000 g/m² or less. The thickness of the sealing layer 234 may be determined such that the mass of the photovoltaic module 112 is 1200 g/m² or less. The thickness of the sealing layer 234 may be determined such that the mass of the photovoltaic module 112 is 500 g/m² or less. The mass of the photovoltaic module 112 may also be a mass per installation area of the photovoltaic module 112, or may also be a mass per area of the solar power generation panel.

### (Composition of sealing layer 234)

In the present embodiment, the sealing layer 234 contains a resin material (not illustrated) and the wavelength conversion material 274. In the present embodiment, the resin material of the sealing layer 234 and the resin material of the front surface protection layer 232 are different in type and/or composition. The wavelength conversion material 274 will be described in detail later.

As the resin material, various materials known as an encapsulant for a solar cell are used. Examples of the resin material include at least one type selected from an ethylene-vinyl acetate copolymer resin (EVA), a polyolefin elastomer (POE), a silicone resin (SI), or an ionomer resin.

### (Optical characteristics of sealing layer 234)

The sealing layer 234 may have a refractive index larger than that of the front surface protection layer 232. Accordingly, a reflection loss is suppressed. Examples of the material composition of the sealing layer 234 include a resin having a refractive index of about 1.5 to 1.6. Examples of the resin having a refractive index of about 1.5 to 1.6 include an ethylene-vinyl acetate copolymer resin (EVA resin).

The sealing layer 234 is preferably substantially transparent to ultraviolet light. The transmittance of light having a wavelength of 200 nm to 450 nm in the sealing layer 234 may be 80% or more. The transmittance is measured by, for example, an ultraviolet-visible-near infrared spectrophotometer.

The sealing layer 234 is preferably substantially transparent to visible light and/or near-infrared light. The transmittance of light having a wavelength of 380 nm to 780 nm in the sealing layer 234 may be 80% or more. The transmittance of light having a wavelength of 800 nm to 1600 nm in the sealing layer 234 may be 80% or more. The transmittance is measured by, for example, an ultraviolet-visible-near infrared spectrophotometer.

In the present embodiment, the back surface protection layer 236 is disposed on a surface of the sealing layer 234 opposite to a surface on which the front surface protection layer 232 is disposed, among two surfaces of the sealing layer 234. The two surfaces of the sealing layer 234 may be surfaces substantially perpendicular to the thickness direction of the sealing layer 234. The back surface protection layer 236 is disposed between the sealing layer 234 and a wing surface 20 of the flight vehicle 100.

In one embodiment, the back surface protection layer 236 is disposed in contact with a surface of the sealing layer 234 on the side of the wing surface 20. In another embodiment, another layer may be interposed between the back surface protection layer 236 and the sealing layer 234.

In one embodiment, the back surface protection layer 236 is disposed in contact with the wing surface 20. In another embodiment, another layer may be interposed between the back surface protection layer 236 and the wing surface 20.

In the present embodiment, the back surface protection layer 236 bonds the photovoltaic module 112 and the wing surface 20 of the flight vehicle 100. The material composition and shape of the back surface protection layer 236 are not particularly limited. Examples of the back surface protection layer 236 include an adhesive, an adhesive layer containing an adhesive and a resin material, a pressure-sensitive adhesive, a pressure-sensitive adhesive layer containing a pressure-sensitive adhesive and a resin material, and the like.

The photoelectric conversion cell 240 converts light energy of incident light into electric energy. As the photoelectric conversion cell 240, a cell having any known structure is used. Examples of the photoelectric conversion cell 240 include a silicon-based photovoltaic element, a III-V-based photovoltaic element, a perovskite-type photovoltaic element, a CIS solar cell, a CIGS solar cell, a dye-sensitized electromotive element, an organic thin-film photovoltaic element, and the like.

In the present embodiment, the n-type semiconductor layer 252 includes an n-type semiconductor. In the present embodiment, the p-type semiconductor layer 254 includes a p-type semiconductor. In the present embodiment, the light-receiving surface electrode 256 is electrically connected to the n-type semiconductor. The light-receiving surface electrode 256 may be a comb-shaped electrode having a finger region and a bus bar region. In the present embodiment, the back surface electrode 258 is electrically connected to the p-type semiconductor layer 254. In the present embodiment, the positive electrode terminal 262 is electrically connected to the back surface electrode 258. In the present embodiment, the negative electrode terminal 264 is electrically connected to the light-receiving surface electrode 256.

In the present embodiment, the wavelength conversion material 272 converts the wavelength of light. The wavelength conversion material 272 converts, for example, at least a part of light of 100 nm to 500 nm into light of different wavelengths. The wavelength conversion material 272 may convert at least a part of light of 100 nm to 400 nm into light of different wavelengths.

In the present embodiment, the wavelength conversion material 272 is excited by light incident on the photovoltaic module 112 and emits light having a specific wavelength. For example, the wavelength conversion material 272 is excited by light in the second wavelength region and emits light having a wavelength longer than that of the excitation light. The second wavelength region includes, for example, a fourth wavelength region included in a range of 100 nm or more and 400 nm or less. The second wavelength region and the fourth wavelength region will be described in detail later.

In one embodiment, the wavelength conversion material 272 emits light having a wavelength at which the conversion efficiency by the photoelectric conversion element is relatively excellent. The wavelength conversion material 272 emits light having a wavelength of 380 nm or more, for example. The wavelength conversion material 272 may emit light having a wavelength of 400 nm or more. In another embodiment, the wavelength conversion material 272 emits light having a wavelength included in an excitation band of the wavelength conversion material 274.

The wavelength conversion material 272 contains, for example, one or more types of materials having an excitation band of a wavelength of 100 to 500 nm and having an emission peak at a wavelength of 380 to 780 nm. Two or more types of wavelength conversion materials 272 may be used in combination. The wavelength conversion material 272 may contain a material that emits blue light (wavelength of 440 to 480 nm), green light (wavelength of 500 to 540 nm), yellow light (wavelength of 540 to 595 nm), or red light (wavelength of 600 to 700 nm).

In the present embodiment, the wavelength conversion material 272 contains at least one of an inorganic phosphor or an organic phosphor. Examples of the wavelength conversion material 272 include an organic dye, a rare earth complex, an inorganic crystal or a glass doped with luminescent ions, an inorganic phosphor nanoparticle, a quantum dot, an oxide phosphor nanoparticle, and the like. The quantum dot may be a semiconductor particle of a size that exhibits a quantum confinement effect.

The wavelength conversion material 272 may contain an inorganic phosphor. Examples of the inorganic phosphor include at least one type selected from the group consisting of an oxide phosphor, a nitride phosphor, an oxynitride phosphor, a chloride phosphor, an acid chloride phosphor, a sulfide phosphor, a halide phosphor, an aluminate phosphor, a halophosphate chloride phosphor, and a silica-based phosphor. The silica-based phosphor is a phosphor in which silica is used as a main component of a base material of a fluorescent light emitting material, and examples of the silica-based phosphor include a composite oxide containing particulate silica and a europium compound. The silica-based phosphor may contain aluminum and europium.

The inorganic phosphor is superior to the organic phosphor in durability in the stratospheric environment. The inorganic phosphor is superior to the organic phosphor in weather resistance and/or durability against ultraviolet light. According to the present embodiment, the front surface protection layer 232 containing the wavelength conversion material 272 is disposed outside the sealing layer 234 containing the wavelength conversion material 274. Accordingly, for example, in a case where the wavelength conversion material 272 converts light in the ultraviolet region into light having a wavelength longer than that of the light, the amount of ultraviolet light to which the wavelength conversion material 274 is exposed is reduced.

Examples of the inorganic phosphor having an excitation band in an ultraviolet to near-ultraviolet region of a wavelength of 300 to 440 nm and emitting blue light include (Sr,Ba)MgAl₁₀O₁₇:Eu²⁺, (Sr,Ba)₃MgSi₂O₈:Eu²⁺, and the like. Examples of the inorganic phosphor having an excitation band in the ultraviolet to near-ultraviolet region of a wavelength of 300 to 440 nm and emitting green light include SrAl₂O₄:Eu²⁺, SrBaSiO₄: Eu²⁺, Y₃(Al,Gd)₅O₁₂:Ce³⁺, SrSiON:Eu²⁺, BaMgAl₁₀O₁₇:Eu²⁺, Mn²⁺, Ba₂MgSi₂O₇:Eu²⁺, Ba₂SiO₄:Eu²⁺, Ba₂Li₂Si₂O₇:Eu²⁺, BaAl₂O₄:Eu²⁺, and the like. Examples of the inorganic phosphor having an excitation band in the ultraviolet to near-ultraviolet region of a wavelength of 300 to 440 nm and emitting yellow light include La₃Si₆N₁₁:Ce³⁺, and the like. Examples of the inorganic phosphor having an excitation band in the ultraviolet to near-ultraviolet region of a wavelength of 300 to 440 nm and emitting red light include MgSr₃Si₂O₈:Eu²⁺, Mn²⁺, Ca₂MgSi₂O₇:Eu²⁺, Mn²⁺, and the like.

Examples of the inorganic phosphor having an excitation band in a blue region of a wavelength of 440 to 480 nm and emitting green light include SrAl₂O₄:Eu²⁺, SrBaSiO₄:Eu²⁺, Y₃(Al,Gd)₅O₁₂:Ce³⁺, SrSiON:Eu²⁺, β-SiAlON:Eu²⁺, and the like. Examples of the inorganic phosphor having an excitation band in the blue region of a wavelength of 440 to 480 nm and emitting yellow light include Y₃(Al,Gd)₅O₁₂:Ce³⁺, Sr₂SiO₄:Eu²⁺, and the like. Examples of the inorganic phosphor having an excitation band in the blue region of a wavelength of 440 to 480 nm and emitting red light include CaAlSiN₃:Eu²⁺, CaSiN₃:Eu²⁺, (Ca,Sr)₂Si₅N₈:Eu²⁺, α-SiAlON:Eu²⁺, and the like.

The content of the wavelength conversion material 272 in the front surface protection layer 232 may be 10 mass% or less, and is preferably 1 to 8 mass%. In a case where the content of the wavelength conversion material 272 is within the above numerical range, for example, even if the thickness of the front surface protection layer 232 is 20 µm or more and 50 µm or less, an amount of ultraviolet light sufficient to improve the conversion efficiency of the photoelectric conversion cell 240 can be converted into visible light or near-infrared light.

The content of the wavelength conversion material 272 may be determined in consideration of the transmittance of the front surface protection layer 232 for ultraviolet light. The content of the wavelength conversion material 272 may be determined such that the transmittance of the front surface protection layer 232 for ultraviolet light is 90% or more. The content of the wavelength conversion material 272 is determined, for example, such that the transmittance of the front surface protection layer 232 for light having a wavelength of 250 nm to 1600 nm is 90% or more. The transmittance is measured by, for example, an ultraviolet-visible-near infrared spectrophotometer. The front surface protection layer 232 may be an example of a layer containing the wavelength conversion material 272.

In the present embodiment, the wavelength conversion material 274 converts the wavelength of light. The wavelength conversion material 274 converts, for example, at least a part of light of 100 nm to 500 nm into light of different wavelengths. The wavelength conversion material 274 may convert at least a part of light of 100 nm and 400 nm into light of different wavelengths.

In the present embodiment, the wavelength conversion material 274 is excited by light incident on the photovoltaic module 112 and/or light emitted by the wavelength conversion material 272, and emits light having a specific wavelength. The wavelength conversion material 274 is excited by light of the first wavelength region and emits light having a wavelength longer than that of the excitation light. The first wavelength region includes, for example, a third wavelength region included in a range of 100 nm or more and 400 nm or less. The first wavelength region and the third wavelength region will be described in detail later.

An upper limit value of the first wavelength region is different from, for example, an upper limit value of the second wavelength region described above. A lower limit value of the first wavelength region is different from, for example, a lower limit value of the second wavelength region described above. An upper limit value of the third wavelength region is different from, for example, an upper limit value of the fourth wavelength region described above. A lower limit value of the third wavelength region is different from, for example, a lower limit value of the fourth wavelength region described above.

In one embodiment, a maximum excitation wavelength of the wavelength conversion material 274 and a maximum excitation wavelength of the wavelength conversion material 272 are different from each other. In another embodiment, a maximum fluorescence wavelength of the wavelength conversion material 274 and a maximum fluorescence wavelength of the wavelength conversion material 272 are different from each other.

In one embodiment, the wavelength conversion material 274 may convert a wavelength of light on a longer wavelength side than the light of which the wavelength is converted by the wavelength conversion material 272. For example, the wavelength conversion material 274 has an excitation band on a longer wavelength side than the wavelength conversion material 272. In another embodiment, the wavelength conversion material 274 may convert a wavelength of light on a shorter wavelength side than the light of which the wavelength is converted by the wavelength conversion material 272. For example, the wavelength conversion material 274 has an excitation band on a shorter wavelength side than the wavelength conversion material 272. The wavelength conversion material 272 may have a configuration similar to that of the second wavelength conversion material described above, and the wavelength conversion material 274 may have a configuration similar to that of the first wavelength conversion material described above.

In the present embodiment, the wavelength conversion material 274 emits light having a wavelength at which the conversion efficiency by the photoelectric conversion element is relatively excellent. The wavelength conversion material 274 emits light having a wavelength of 380 nm or more, for example. The wavelength conversion material 274 may emit light having a wavelength of 400 nm or more. Accordingly, the conversion efficiency of the photoelectric conversion cell 240 is improved.

The wavelength conversion material 274 contains, for example, one or more types of materials having an excitation band of a wavelength of 100 to 500 nm and having an emission peak at a wavelength of 380 to 780 nm. Two or more types of wavelength conversion materials 274 may be used in combination. The wavelength conversion material 274 may contain a material that emits blue light (wavelength of 440 to 480 nm), green light (wavelength of 500 to 540 nm), yellow light (wavelength of 540 to 595 nm), or red light (wavelength of 600 to 700 nm).

In the present embodiment, the wavelength conversion material 274 contains at least one of an inorganic phosphor or an organic phosphor. Examples of the wavelength conversion material 274 include an organic dye, a rare earth complex, an inorganic crystal or a glass doped with luminescent ions, an inorganic phosphor nanoparticle, a quantum dot, an oxide phosphor nanoparticle, and the like. The quantum dot may be a semiconductor particle of a size that exhibits a quantum confinement effect.

The wavelength conversion material 274 may contain an inorganic phosphor similar to the inorganic phosphor described in relation to the wavelength conversion material 272. The wavelength conversion material 274 may contain an organic phosphor. Examples of the organic phosphor include an organic dye, a luminescent rare earth complex, and the like. Examples of the luminescent rare earth complex include a lanthanide complex such as an Eu (III) complex.

The content of the wavelength conversion material 274 in the sealing layer 234 may be 10 mass% or less, and is preferably 1 to 8 mass%. In a case where the content of the wavelength conversion material 274 is within the above numerical range, for example, even if the thickness of the sealing layer 234 is 20 µm or more and 100 µm or less, an amount of ultraviolet light sufficient to improve the conversion efficiency of the photoelectric conversion cell 240 can be converted into visible light or near-infrared light. Accordingly, for example, the conversion efficiency on the ground can be improved by 2% or more. In addition, the conversion efficiency in the stratospheric environment can be improved by 4% or more.

The content of the wavelength conversion material 274 may be determined in consideration of the transmittance of the sealing layer 234 for ultraviolet light. The content of the wavelength conversion material 274 is determined, for example, such that the transmittance of the sealing layer 234 for light having a wavelength of 250 nm to 1600 nm is 90% or more. The content of the wavelength conversion material 274 may be determined such that the transmittance of the sealing layer 234 for light having a wavelength of 250 nm to 1600 nm is 80% or more. The transmittance is measured by, for example, an ultraviolet-visible-near infrared spectrophotometer. The sealing layer 234 may be an example of a layer containing the wavelength conversion material 274. In one embodiment, the transmittance of the sealing layer 234 for ultraviolet light is 80% or more, and the transmittance of the front surface protection layer 232 for ultraviolet light is 90% or more. In another embodiment, the transmittance of the sealing layer 234 for ultraviolet light is 90% or more, and the transmittance of the front surface protection layer 232 for ultraviolet light is 90% or more.

The front surface protection layer 232 may be an example of the second wavelength conversion layer. The resin material contained in the front surface protection layer 232 may be an example of the second resin. The sealing layer 234 may be an example of the first wavelength conversion layer. The resin material contained in the sealing layer 234 may be an example of the first resin. The photoelectric conversion cell 240 may be an example of the photoelectric conversion element. The wavelength conversion material 272 may be an example of the second wavelength conversion material. The wavelength conversion material 274 may be an example of the first wavelength conversion material.

### (Example of another embodiment)

In the present embodiment, the photovoltaic module 112 has been described in detail by taking, as an example, a case where the photovoltaic module 112 does not have an optical confinement structure. However, the photovoltaic module 112 is not limited to the present embodiment. In another embodiment, the photovoltaic module 112 may include an optical confinement structure for efficiently confining light within the photovoltaic module 112.

For example, the photovoltaic module 112 has a fine uneven structure on its surface on a side where light is incident (may be referred to as outside). For example, the photovoltaic module 112 has a reflection portion, which reflects light traveling from the inside of the photovoltaic module 112 toward the outside of the photovoltaic module 112, on its side surface connecting the front surface 222 and the back surface 224. For example, the photovoltaic module 112 has the reflection portion that reflects light traveling from the inside of the photovoltaic module 112 toward the outside of the photovoltaic module 112, between the back surface protection layer 236 and the sealing layer 234, at an interface between the back surface protection layer 236 and the sealing layer 234, or on a surface of the back surface protection layer 236 on the back surface 224 side. The back surface protection layer 236 may function as the reflection layer.

The optical confinement structure may be configured to confine light in a wavelength region corresponding to ultraviolet light. Accordingly, the wavelength of ultraviolet light can be converted efficiently. As a result, the power generation efficiency of the photovoltaic module 112 is improved. The optical confinement structure may be configured to confine light in a wavelength region where the conversion efficiency by the photoelectric conversion cell 240 is relatively high. Accordingly, the power generation efficiency of the photovoltaic module 112 is improved.

In the present embodiment, the photoelectric conversion cell 240 has been described in detail by taking, as an example, a case where the photoelectric conversion cell 240 generates power by using a pn junction. However, the photoelectric conversion cell 240 is not limited to the present embodiment. In another embodiment, for example, the photoelectric conversion cell 240 generates power by using a pin junction.

In the present embodiment, the photoelectric conversion cell 240 has been described in detail by taking, as an example, a case where the light-receiving surface electrode 256 is disposed on the front surface 242 side of the photoelectric conversion cell 240. However, the photoelectric conversion cell 240 is not limited to the present embodiment. In another embodiment, for example, the photoelectric conversion cell 240 may have a back electrode type structure having no electrode on the front surface 242 side.

In the present embodiment, the photovoltaic module 112 and the photoelectric conversion cell 240 have been described in detail by taking, as an example, a case where the photovoltaic module 112 and the photoelectric conversion cell 240 have a single-sided light-receiving structure. However, the photovoltaic module 112 and the photoelectric conversion cell 240 are not limited to the present embodiment. In another embodiment, at least one of the photovoltaic module 112 or the photoelectric conversion cell 240 may have a double-sided light-receiving structure.

In the present embodiment, the photovoltaic module 112 has been described in detail by taking, as an example, a case where the sealing layer 234 seals the entire photoelectric conversion cell 240. However, the photovoltaic module 112 is not limited to the present embodiment. In another embodiment, the sealing layer 234 seals a part of the photoelectric conversion cell 240. For example, the photoelectric conversion cell 240 is sealed by the sealing layer 234 and the back surface protection layer 236. For example, the photoelectric conversion cell 240 is disposed such that the back surface 244 of the photoelectric conversion cell 240 is in contact with the back surface protection layer 236. In addition, the sealing layer 234 is disposed so as to cover the photoelectric conversion cell 240. Accordingly, the front surface 242 and the side surface 246 of the photoelectric conversion cell 240 are sealed by the sealing layer 234.

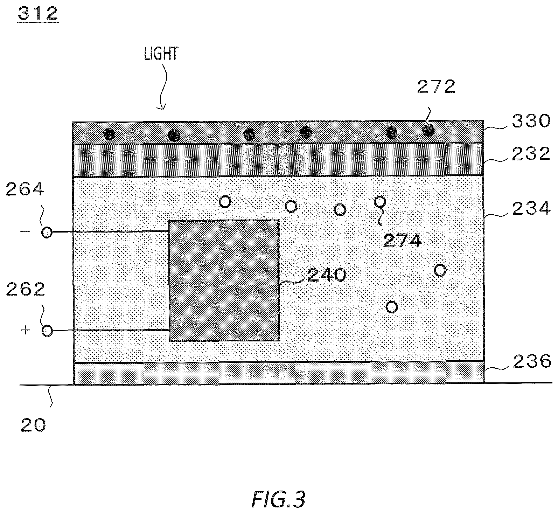

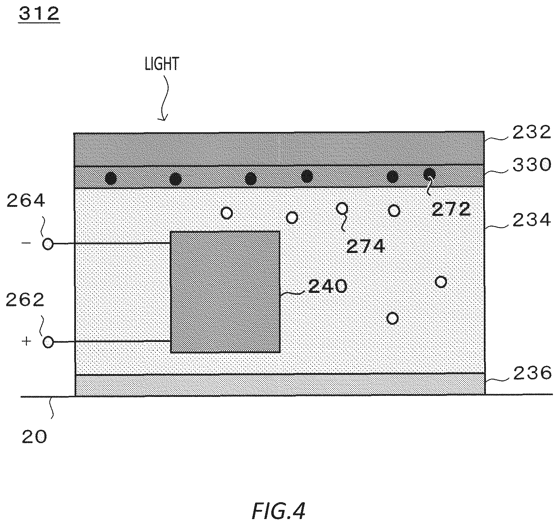

A photovoltaic module 312, which is another example of the photovoltaic module 112, will be described in detail with reference to Figs. 3 and 4. The photovoltaic module 312 is different from the photovoltaic module 112 in that the photovoltaic module 312 includes another layer having a larger content of the wavelength conversion material 272 than that of the front surface protection layer 232. For example, the photovoltaic module 312 is different from the photovoltaic module 112 in that the wavelength conversion material 272 is disposed in a layer different from the front surface protection layer 232.

Fig. 3 schematically illustrates an example of an internal configuration of the photovoltaic module 312. In the present embodiment, the photovoltaic module 312 is different from the photovoltaic module 112 in that a conversion layer 330 containing the wavelength conversion material 272 is provided outside the front surface protection layer 232 and that the front surface protection layer 232 does not contain the wavelength conversion material 272. With respect to other features, the photovoltaic module 312 may have a configuration similar to that of the photovoltaic module 112.

In the present embodiment, the conversion layer 330 contains a resin material (not illustrated) and the wavelength conversion material 272. In the present embodiment, the resin material of the conversion layer 330 and the resin material of the sealing layer 234 are different in type and/or composition. In the present embodiment, the resin material of the conversion layer 330 and the resin material of the front surface protection layer 232 are different in type and/or composition. As the resin material of the conversion layer 330, for example, various resins exemplified in relation to the front surface protection layer 232 are used.

In the present embodiment, the content of the wavelength conversion material 272 in the conversion layer 330 may be larger than the content of the wavelength conversion material 272 in the front surface protection layer 232. The content of the wavelength conversion material 272 in the conversion layer 330 may be 10 mass% or less, and is preferably 1 to 8 mass%.

The conversion layer 330 may have optical characteristics similar to those of the front surface protection layer 232. The conversion layer 330 may have a refractive index larger than that of the front surface protection layer 232. In this case, the sealing layer 234 may have a refractive index larger than that of the front surface protection layer 232. Accordingly, a reflection loss is suppressed. An absolute value of a difference between the refractive index of the conversion layer 330 and the refractive index of the front surface protection layer 232 may be 0.01 or more and 2.5 or less. The absolute value of the difference may also be 0.05 or more and 2 or less, 0.05 or more and 1 or less, 0.05 or more and 0.5 or less, or 0.05 or more and 0.1 or less. An absolute value of a difference between the refractive index of the front surface protection layer 232 and the refractive index of the sealing layer 234 may be 0.01 or more and 2.5 or less. The absolute value of the difference may also be 0.05 or more and 2 or less, 0.05 or more and 1 or less, 0.05 or more and 0.5 or less, or 0.05 or more and 0.1 or less.

In the present embodiment, the wavelength conversion material 272 preferably contains an inorganic phosphor. The wavelength conversion material 274 may contain an inorganic phosphor and/or an organic phosphor. The content of the organic phosphor in the sealing layer 234 may be larger than the content of the organic phosphor in the conversion layer 330.

The sealing layer 234 may be an example of the first wavelength conversion layer. The conversion layer 330 may be an example of the second wavelength conversion layer.

Fig. 4 schematically illustrates another example of the internal configuration of the photovoltaic module 312. In the present embodiment, the photovoltaic module 312 is different from the photovoltaic module 312 described in relation to Fig. 3 in that the photovoltaic module 312 includes the conversion layer 330 between the front surface protection layer 232 and the sealing layer 234. With respect to other features, the photovoltaic module 312 according to the present embodiment may have a configuration similar to that of the photovoltaic module 312 described in relation to Fig. 3.

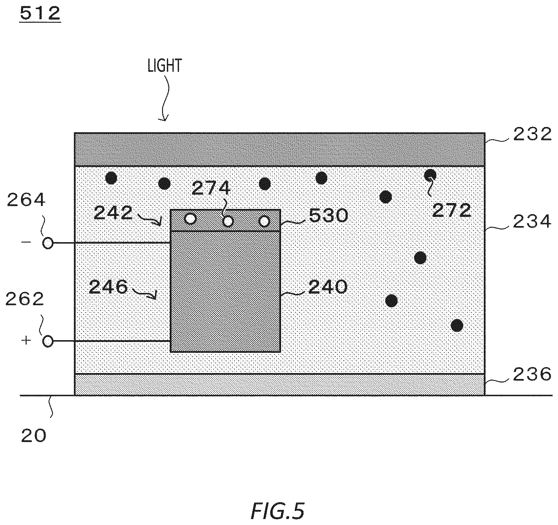

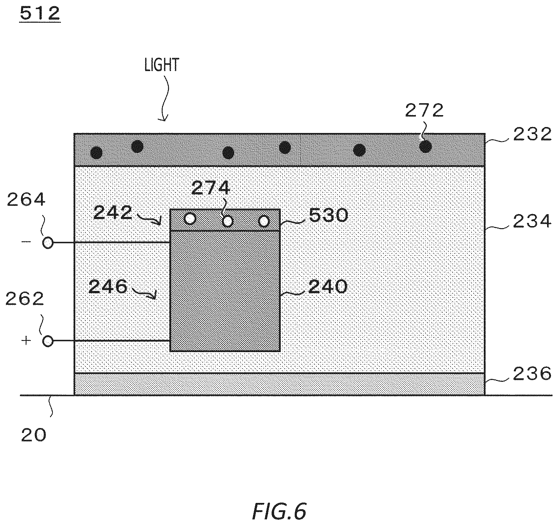

A photovoltaic module 512, which is another example of the photovoltaic module 112, will be described in detail with reference to Figs. 5 and 6. The photovoltaic module 512 is different from the photovoltaic module 112 in that a coating layer 530 which is thinner than the front surface protection layer 232 is provided on the front surface 242 of the photoelectric conversion cell 240 and that the front surface protection layer 232 and/or the sealing layer 234 contains the wavelength conversion material 272 and the coating layer 530 contains the wavelength conversion material 274.

Fig. 5 schematically illustrates an example of an internal configuration of the photovoltaic module 512. In the present embodiment, the photovoltaic module 512 includes the coating layer 530 on the front surface 242 of the photoelectric conversion cell 240.

In the present embodiment, the coating layer 530 contains a resin material (not illustrated) and the wavelength conversion material 274. The thickness of the coating layer 530 may be 5 µm or more and 50 µm or less. The thickness of the coating layer 530 may also be less than 10 µm. The thickness of the coating layer 530 may also be less than 1 µm, or may also be less than 0.1 µm. The content of the wavelength conversion material 274 in the coating layer 530 may be 5 mass%.

### (Optical characteristics of coating layer 530)

The coating layer 530 may have a refractive index larger than that of the sealing layer 234. Accordingly, a reflection loss is suppressed.

The coating layer 530 is preferably substantially transparent to ultraviolet light. The transmittance of light having a wavelength of 200 nm to 450 nm in the coating layer 530 may be 80% or more. In this case, the transmittance of light having a wavelength of 200 nm to 450 nm in the sealing layer 234 may also be 90% or more, or may also be 95% or more. The transmittance is measured by, for example, an ultraviolet-visible-near infrared spectrophotometer.

The coating layer 530 is preferably substantially transparent to visible light and/or near-infrared light. The transmittance of light having a wavelength of 380 nm to 780 nm in the coating layer 530 may be 80% or more. The transmittance of light having a wavelength of 800 nm to 1600 nm in the coating layer 530 may be 80% or more. The transmittance is measured by, for example, an ultraviolet-visible-near infrared spectrophotometer.

The reflectance of light having a wavelength of 200 nm to 450 nm in the coating layer 530 may be less than 5%. Accordingly, a reflection loss is suppressed.

The coating layer 530 is produced, for example, by the following procedure. First, the wavelength conversion material 274 and a solvent are mixed to prepare a paste or slurry of the wavelength conversion material 274. Next, the paste or slurry is applied to the front surface 242 of the photoelectric conversion cell 240. Thereafter, a step of drying the paste or slurry is performed. Accordingly, the coating layer 530 is formed on the front surface 242 of the photoelectric conversion cell 240.

In the present embodiment, the sealing layer 234 is disposed so as to cover the coating layer 530 disposed on the front surface 242 of the photoelectric conversion cell 240 and at least a part of the side surface 246 of the photoelectric conversion cell 240. For example, the sealing layer 234 is disposed so as to entirely cover the coating layer 530 and a junction between the n-type semiconductor layer 252 and the p-type semiconductor layer 254.

In the present embodiment, the sealing layer 234 contains the wavelength conversion material 272. The content of the wavelength conversion material 272 in the sealing layer 234 may be 10 mass% or less, or may also be 8 mass% or less. The content of the wavelength conversion material 272 in the sealing layer 234 is preferably 1 to 8 mass%.

The content of the wavelength conversion material 272 may be determined in consideration of the transmittance of the sealing layer 234 for ultraviolet light. The content of the wavelength conversion material 272 is determined, for example, such that the transmittance of the sealing layer 234 for light having a wavelength of 250 nm to 1600 nm is 90% or more. The content of the wavelength conversion material 272 may be determined such that the transmittance of the sealing layer 234 for light having a wavelength of 250 nm to 1600 nm is 80% or more. The transmittance is measured by, for example, an ultraviolet-visible-near infrared spectrophotometer. The sealing layer 234 may be an example of the layer containing the wavelength conversion material 272.

In one embodiment, the sealing layer 234 may have a configuration similar to that of the sealing layer 234 described in relation to the photovoltaic module 112, except that the sealing layer 234 contains the wavelength conversion material 272 instead of the wavelength conversion material 274. In another embodiment, the sealing layer 234 may have a configuration similar to that of the front surface protection layer 232 described in relation to the photovoltaic module 112.

The coating layer 530 may be an example of the first wavelength conversion layer. The sealing layer 234 may be an example of the second wavelength conversion layer.

Fig. 6 schematically illustrates another example of the internal configuration of the photovoltaic module 512. In the present embodiment, the photovoltaic module 512 is different from the photovoltaic module 512 described in relation to Fig. 5 in that the front surface protection layer 232 contains the wavelength conversion material 272 and the sealing layer 234 does not contain the wavelength conversion material 272. In the present embodiment, the sealing layer 234 is disposed between the coating layer 530 and the front surface protection layer 232. With respect to other features, the photovoltaic module 512 according to the present embodiment may have a configuration similar to that of the photovoltaic module 512 described in relation to Fig. 5.

The coating layer 530 may be an example of the first wavelength conversion layer. The front surface protection layer 232 may be an example of the second wavelength conversion layer. The sealing layer 234 may be an example of the intermediate layer.

### (Example of another embodiment)

The sealing layer 234 may contain the wavelength conversion material 272 and may contain the wavelength conversion material 274. The content of the wavelength conversion material 272 in the sealing layer 234 may be smaller than the content of the wavelength conversion material 272 in the front surface protection layer 232. The content of the wavelength conversion material 274 in the sealing layer 234 may be smaller than the content of the wavelength conversion material 274 in the coating layer 530.

In the present embodiment, the photovoltaic module 512 has been described in detail by taking, as an example, a case where the front surface protection layer 232 and the sealing layer 234 are in contact with each other. However, the photovoltaic module 512 is not limited to the present embodiment. In another embodiment, another layer may be interposed between the front surface protection layer 232 and the sealing layer 234.

In the present embodiment, the photovoltaic module 512 has been described in detail by taking, as an example, a case where the wavelength conversion material 272 is contained in the front surface protection layer 232. However, the photovoltaic module 512 is not limited to the present embodiment. In another embodiment, similarly to the embodiments described in relation to Figs. 3 and 4, the photovoltaic module 512 may include the conversion layer 330 containing the wavelength conversion material 272. In this case, the front surface protection layer 232 may not contain the wavelength conversion material 272. The content of the wavelength conversion material 272 in the wavelength conversion material 272 may be smaller than the content of the wavelength conversion material 272 in the conversion layer 330.

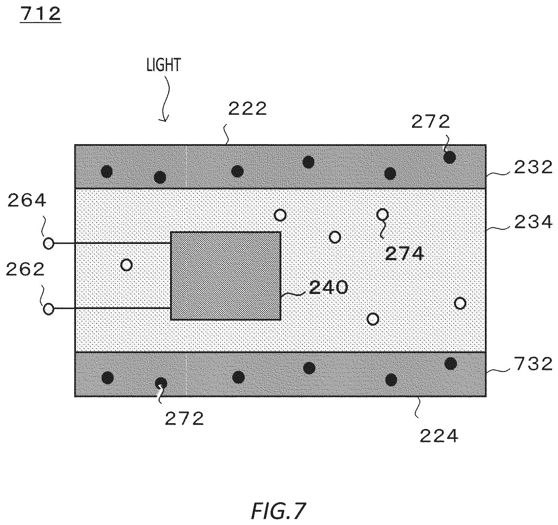

Another example of the photovoltaic module 112 will be described in detail with reference to Figs. 7, 8, and 9. According to embodiments described in relation to Figs. 7, 8 and 9, a double-sided light-receiving photovoltaic module is provided.

Fig. 7 schematically illustrates an example of an internal configuration of a photovoltaic module 712. The photovoltaic module 712 may be a double-sided light-receiving photovoltaic module corresponding to the single-sided light-receiving photovoltaic module 112 described in relation to Fig. 2. The photovoltaic module 712 may have a configuration similar to that of the photovoltaic module 112 except that the photovoltaic module 712 has a double-sided light-receiving structure.

In the present embodiment, the photovoltaic module 712 is different from the photovoltaic module 112 in that the front surface protection layer 232, the sealing layer 234, and a back surface protection layer 732 are laminated in this order. The back surface protection layer 732 contains the wavelength conversion material 272. The back surface protection layer 732 may have a configuration similar to that of the front surface protection layer 232.

In one embodiment, the photovoltaic module 712 includes the back surface protection layer 236 and is adhered to the wing surface 20 by the back surface protection layer 236. In another embodiment, the photovoltaic module 712 may not include the back surface protection layer 236.

The photovoltaic module 712 may be an example of the photoelectric conversion apparatus. The front surface protection layer 232 may be an example of the second wavelength conversion layer. The sealing layer 234 may be an example of the first wavelength conversion layer. The back surface protection layer 732 may be an example of the second wavelength conversion layer. The resin material contained in the back surface protection layer 732 may be an example of the second resin.

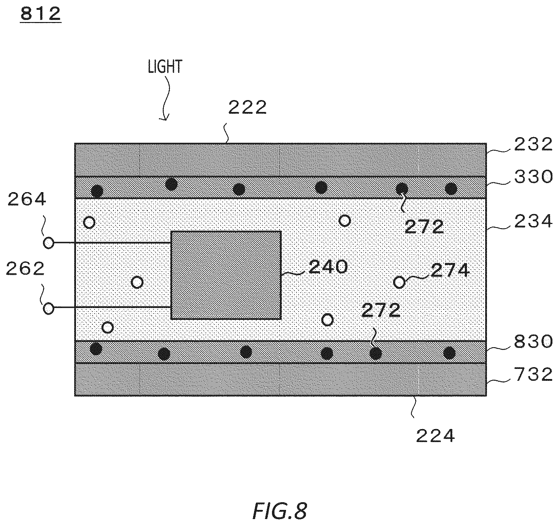

Fig. 8 schematically illustrates an example of an internal configuration of a photovoltaic module 812. The photovoltaic module 812 may be a double-sided light-receiving photovoltaic module corresponding to the single-sided light-receiving photovoltaic module 312 described in relation to Fig. 4. The photovoltaic module 812 may have a configuration similar to that of the photovoltaic module 312 except that the photovoltaic module 812 has a double-sided light-receiving structure.

In the present embodiment, the photovoltaic module 812 is different from the photovoltaic module 312 in that the front surface protection layer 232, the conversion layer 330, the sealing layer 234, a conversion layer 830, and the back surface protection layer 732 are laminated in this order. The conversion layer 830 contains the wavelength conversion material 272. The conversion layer 830 may have a configuration similar to that of the conversion layer 330.

In one embodiment, the photovoltaic module 812 includes the back surface protection layer 236 and is adhered to the wing surface 20 by the back surface protection layer 236. In another embodiment, the photovoltaic module 812 may not include the back surface protection layer 236.

The photovoltaic module 812 may be an example of the photoelectric conversion apparatus. The sealing layer 234 may be an example of the first wavelength conversion layer. The conversion layer 330 may be an example of the second wavelength conversion layer. The conversion layer 830 may be an example of the second wavelength conversion layer. The resin material contained in the conversion layer 830 may be an example of the second resin.

### (Example of another embodiment)

In the present embodiment, the photovoltaic module 812 has been described in detail by taking, as an example, a case where the photovoltaic module 812 is a double-sided light-receiving photovoltaic module corresponding to the single-sided light-receiving photovoltaic module 312 described in relation to Fig. 4. However, the photovoltaic module 812 is not limited to the present embodiment. In another embodiment, the photovoltaic module 812 may also be a double-sided light-receiving photovoltaic module corresponding to the single-sided light-receiving photovoltaic module 312 described in relation to Fig. 3.

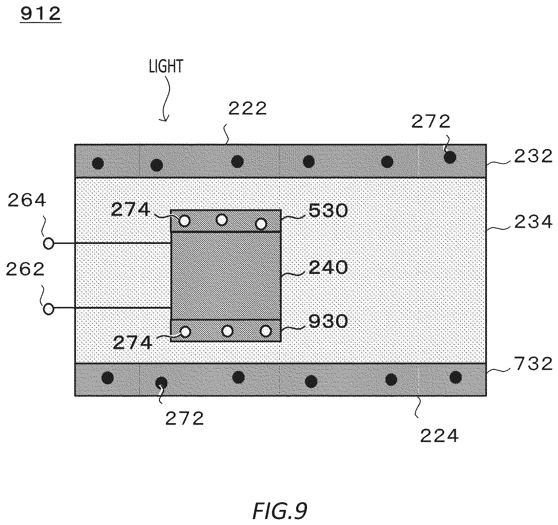

Fig. 9 schematically illustrates an example of an internal configuration of a photovoltaic module 912. The photovoltaic module 912 may be a double-sided light-receiving photovoltaic module corresponding to the single-sided light-receiving photovoltaic module 512 described in relation to Fig. 6. The photovoltaic module 912 may have a configuration similar to that of the photovoltaic module 512 except that the photovoltaic module 912 has a double-sided light-receiving structure.

In the present embodiment, the photovoltaic module 912 is different from the photovoltaic module 512 in that the front surface protection layer 232, the sealing layer 234, and the back surface protection layer 732 are laminated in this order and that the coating layer 530 is disposed on the front surface 242 side of the photoelectric conversion cell 240 and a coating layer 930 is disposed on the back surface 244 side of the photoelectric conversion cell 240.

In the present embodiment, the front surface protection layer 232 and the back surface protection layer 732 contain the wavelength conversion material 272. The back surface protection layer 732 may have a configuration similar to that of the front surface protection layer 232. In the present embodiment, the coating layer 530 and the coating layer 930 contain the wavelength conversion material 274. The coating layer 930 may have a configuration similar to that of the coating layer 530.

In one embodiment, the photovoltaic module 912 includes the back surface protection layer 236 and is adhered to the wing surface 20 by the back surface protection layer 236. In another embodiment, the photovoltaic module 712 may not include the back surface protection layer 236.

The photovoltaic module 912 may be an example of the photoelectric conversion apparatus. The front surface protection layer 232 may be an example of the second wavelength conversion layer. The coating layer 530 may be an example of the first wavelength conversion layer. The back surface protection layer 732 may be an example of the second wavelength conversion layer. The resin material contained in the back surface protection layer 732 may be an example of the second resin. The coating layer 930 may be an example of the first wavelength conversion layer. The resin material contained in the coating layer 930 may be an example of the first resin.

### (Example of another embodiment)

In the present embodiment, the photovoltaic module 912 has been described in detail by taking, as an example, a case where the photovoltaic module 912 is a double-sided light-receiving photovoltaic module corresponding to the single-sided light-receiving photovoltaic module 512 described in relation to Fig. 6. However, the photovoltaic module 912 is not limited to the present embodiment. In another embodiment, the photovoltaic module 912 may also be a double-sided light-receiving photovoltaic module corresponding to the single-sided light-receiving photovoltaic module 512 described in relation to Fig. 5.

In the present embodiment, the photovoltaic module 912 has been described in detail by taking, as an example, a case where each of the front surface protection layer 232 and the back surface protection layer 732 is in contact with the sealing layer 234. However, the photovoltaic module 912 is not limited to the present embodiment. In another embodiment, another layer may be disposed between at least one of the front surface protection layer 232 or the back surface protection layer 732, and the sealing layer 234. The another layer may have a configuration similar to that of the conversion layer 330.

In the present embodiment, the photovoltaic module 912 has been described in detail by taking, as an example, a case where the front surface protection layer 232 and the back surface protection layer 732 are disposed on the outermost side of the photovoltaic module 912. However, the photovoltaic module 912 is not limited to the present embodiment. In another embodiment, another layer may be disposed outside at least one of the front surface protection layer 232 or the back surface protection layer 732. The another layer may have a configuration similar to that of the conversion layer 330.

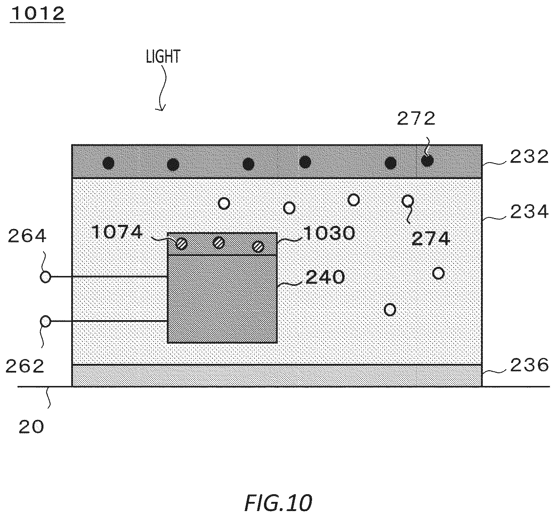

Fig. 10 schematically illustrates an example of an internal configuration of a photovoltaic module 1012. The photovoltaic module 1012 may have a configuration similar to that of the photovoltaic module 112 described in relation to Fig. 2, except that a coating layer 1030 is disposed between the sealing layer 234 and the front surface 242 of the photoelectric conversion cell 240.

In the present embodiment, the coating layer 1030 is disposed in contact with the front surface 242 of the photoelectric conversion cell 240. The coating layer 1030 contains, for example, a resin material (not illustrated) and a UV absorbing material 1074. The coating layer 1030 is different from the coating layer 530 in that the coating layer 1030 contains the UV absorbing material 1074 instead of or together with the wavelength conversion material 274. The coating layer 1030 may have a configuration similar to that of the coating layer 530 except for the above difference.

In the present embodiment, the UV absorbing material 1074 absorbs ultraviolet light. As the UV absorbing material 1074, any known UV absorber is used. The content of the UV absorbing material 1074 in the coating layer 1030 may be 5 mass% or less.

In the present embodiment, the sealing layer 234 is disposed on a side of a surface (an upper surface in the drawing) of the coating layer 1030 opposite to a surface (a lower surface in the drawing) in contact with the photoelectric conversion cell 240, among two surfaces of the coating layer 1030. The sealing layer 234 is disposed so as to cover the coating layer 1030 disposed on the front surface 242 of the photoelectric conversion cell 240 and at least a part of the side surface 246 of the photoelectric conversion cell 240. For example, the sealing layer 234 is disposed so as to entirely cover the coating layer 1030 and a junction between the n-type semiconductor layer 252 and the p-type semiconductor layer 254.

According to the present embodiment, the light incident on the photovoltaic module 1012 is first transmitted through the layer containing the wavelength conversion material 272. The light transmitted through the above layer is then transmitted through the layer containing the wavelength conversion material 274. The light transmitted through the above layer is then transmitted through the layer containing the UV absorbing material 1074 and is incident on the photoelectric conversion cell 240. According to the present embodiment, even in a case where ultraviolet light remains in the light transmitted through the layer containing the wavelength conversion material 272 and the layer containing the wavelength conversion material 274, the ultraviolet light is absorbed by the UV absorbing material 1074. Accordingly, the deterioration of the photoelectric conversion cell 240 due to ultraviolet light is further suppressed.

The photovoltaic module 1012 may be an example of the photoelectric conversion apparatus. The coating layer 1030 may be an example of the absorption layer. The sealing layer 234 may be an example of the conversion layer.

### (Example of another embodiment)

In the present embodiment, the photovoltaic module 1012 has been described in detail by taking, as an example, a case where the photovoltaic module 1012 corresponds to the photovoltaic module 112 described in relation to Fig. 2. However, the photovoltaic module 1012 is not limited to the present embodiment. In another embodiment, the photovoltaic module 1012 may have a configuration similar to that of the photovoltaic modules described in relation to Figs. 3 to 9.

In the present embodiment, the photovoltaic module 1012 has been described in detail by taking, as an example, a case where the thin coating layer 1030 is disposed on the front surface 242 of the photoelectric conversion cell 240. However, the photovoltaic module 1012 is not limited to the present embodiment. In another embodiment, a film having a thickness of 20 µm to 100 µm, preferably 20 µm to 50 µm, and containing the UV absorbing material 1074 may be disposed in contact with the photoelectric conversion cell 240 of the photoelectric conversion cell 240.

While the present invention has been described by way of the embodiments, the technical scope of the present invention is not limited to the scope described in the above-described embodiments. It is apparent to persons skilled in the art that various alterations or improvements can be made to the above-described embodiments. It is also apparent from the described scope of the claims that the embodiments to which such alterations or improvements are made can be included in the technical scope of the present invention.

It should be noted that the operations, procedures, steps, stages or the like of each process performed by an apparatus, system, program, and method shown in the scope of the claims, embodiments, or diagrams can be performed in any order as long as the order is not indicated by "prior to," "before," or the like and as long as the output from a previous process is not used in a later process. Even if the process flow is described by using phrases such as "first", "then" or the like in the scope of the claims, embodiments, or diagrams, it does not necessarily mean that the process must be performed in this order.

### EXPLANATION OF REFERENCES

20: wing surface; 100: flight vehicle; 110: power generation system; 112: photovoltaic module; 120: power control circuit; 122: power accumulation apparatus; 130: electric motor; 140: propeller; 150: sensor; 160: control apparatus; 222: front surface; 224: back surface; 232: front surface protection layer; 234: sealing layer; 236: back surface protection layer; 240: photoelectric conversion cell; 242: front surface; 244: back surface; 246: side surface; 252: n-type semiconductor layer; 254: p-type semiconductor layer; 256: light-receiving surface electrode; 258: back surface electrode; 262: positive electrode terminal; 264: negative electrode terminal; 272: wavelength conversion material; 274: wavelength conversion material; 312: photovoltaic module; 330: conversion layer; 512: photovoltaic module; 530: coating layer; 712: photovoltaic module; 732: back surface protection layer; 812: photovoltaic module; 830: conversion layer; 912: photovoltaic module; 930: coating layer; 1012: photovoltaic module; 1030: coating layer; and 1074: UV absorbing material.

## Claims

1. A photoelectric conversion apparatus comprising:
a photoelectric conversion element which converts light energy of incident light into electric energy;
a first wavelength conversion layer which is disposed in contact with a light receiving surface of the photoelectric conversion element; and
a second wavelength conversion layer which is disposed on a side of a surface of the first wavelength conversion layer opposite to a surface in contact with the photoelectric conversion element, wherein
the first wavelength conversion layer contains a first wavelength conversion material which converts a wavelength of light in a first wavelength region,
the second wavelength conversion layer contains a second wavelength conversion material which converts a wavelength of light in a second wavelength region, and
an upper limit value of the first wavelength region is different from an upper limit value of the second wavelength region, and/or a lower limit value of the first wavelength region is different from a lower limit value of the second wavelength region.

2. The photoelectric conversion apparatus according to claim 1, wherein
the first wavelength region includes a third wavelength region included in a range of 100 nm or more and 400 nm or less,
the second wavelength region includes a fourth wavelength region included in a range of 100 nm or more and 400 nm or less, and
an upper limit value of the third wavelength region is different from an upper limit value of the fourth wavelength region, and/or a lower limit value of the third wavelength region is different from a lower limit value of the fourth wavelength region.

3. The photoelectric conversion apparatus according to claim 1 or 2, wherein
the first wavelength conversion layer contains a first resin and the first wavelength conversion material,
the second wavelength conversion layer contains a second resin and the second wavelength conversion material, and
the first resin and the second resin are different in type and/or composition.

4. The photoelectric conversion apparatus according to claim 3, wherein
the first wavelength conversion layer has a refractive index larger than that of the second wavelength conversion layer.

5. The photoelectric conversion apparatus according to claim 3 or 4, wherein
the first resin is at least one type selected from an ethylene-vinyl acetate copolymer resin (EVA), a polyolefin elastomer (POE), a silicone resin (SI), or an ionomer resin.

6. The photoelectric conversion apparatus according to any one of claims 3 to 5, wherein
the second resin is at least one type selected from a group consisting of polyethylene (PE), ultra-high molecular weight polyethylene (U-PE), polymethyl methacrylate (PMMA), polyethylene terephthalate (PET), polycarbonate (PC), a fluorine-based resin, polyimide (PI), unsaturated polyester (UP), an epoxy resin (EP), and a silicone resin (SI).

7. The photoelectric conversion apparatus according to any one of claims 1 to 6, wherein
the first wavelength conversion layer
is disposed so as to cover at least a part of the light receiving surface of the photoelectric conversion element and a side surface of the photoelectric conversion element, and
has a thickness of 20 µm or more and 100 µm or less.

8. The photoelectric conversion apparatus according to any one of claims 1 to 5, wherein
the first wavelength conversion layer has a thickness of less than 10 µm.

9. The photoelectric conversion apparatus according to claim 8, wherein
the second wavelength conversion layer is disposed so as to cover the first wavelength conversion layer disposed on the light receiving surface of the photoelectric conversion element and at least a part of a side surface of the photoelectric conversion element.

10. The photoelectric conversion apparatus according to claim 8, further comprising
an intermediate layer which is disposed between the first wavelength conversion layer and the second wavelength conversion layer, wherein
the intermediate layer is disposed so as to cover the first wavelength conversion layer disposed on the light receiving surface of the photoelectric conversion element and at least a part of a side surface of the photoelectric conversion element.

11. The photoelectric conversion apparatus according to any one of claims 1 to 10, wherein
the second wavelength conversion layer has a thickness of 20 µm or more and 50 µm or less.

12. The photoelectric conversion apparatus according to any one of claims 1 to 11, wherein
the first wavelength conversion layer has a transmittance of 80% or more for light of 200 nm to 450 nm, and
the second wavelength conversion layer has a transmittance of 90% or more for light of 200 nm to 450 nm.

13. The photoelectric conversion apparatus according to any one of claims 1 to 12, wherein
the first wavelength conversion material contains an organic phosphor.

14. The photoelectric conversion apparatus according to any one of claims 1 to 13, wherein
the second wavelength conversion material contains an inorganic phosphor.

15. The photoelectric conversion apparatus according to any one of claims 1 to 14, wherein
the first wavelength conversion layer includes
an absorption layer which is disposed in contact with a light receiving surface of the photoelectric conversion element and contains a UV absorbing material, and
a conversion layer which is disposed on a side of a surface of the UV absorption layer opposite to a surface in contact with the photoelectric conversion element and contains the first wavelength conversion material.

16. A flight vehicle comprising:
the photoelectric conversion apparatus according to any one of claims 1 to 15; and
a propulsion force generation apparatus which generates a propulsion force by using electric energy generated by the photoelectric conversion apparatus.
